# EUROPEAN PATENT APPLICATION

(11) **EP 4 788 102 A1**
(43) Date of publication of application: **05.08.2026**
(21) Application number: 25845855.3
(22) Date of filing: 26.02.2025
(51) Int. Cl.: H10K 59/121, H10K 59/123, H10K 59/131, H10K 59/12, H10K 59/124

(54) **DISPLAY PANEL, MANUFACTURING METHOD THEREFOR, AND DISPLAY APPARATUS**

(30) Priority: 05.12.2024 CN 202411788035
(71) Applicant: Wuhan Tianma Microelectronics Co., Ltd., Wuhan, Hubei 430205 (CN)
(72) Inventor: YU, Yun, Wuhan, Hubei 430205 (CN)
(74) Representative: Boult Wade Tennant LLP
(86) International application number: PCT/CN2025/079248
(87) International publication number: WO 2026/118242

(57) **Abstract**

The present disclosure provides a display panel, a manufacturing method thereof, and a display apparatus, relating to the field of display technology. The display panel comprises a substrate and an array layer, wherein the array layer is located on one side of the substrate and comprises a first semiconductor layer, a first metal layer, and a second metal layer. The first metal layer is located on a side of the first semiconductor layer facing away from the substrate, and the second metal layer is located on a side of the first metal layer facing away from the substrate. The array layer comprises a first transistor, wherein a first active layer of the first transistor is located in the first semiconductor layer, and a first electrode and a second electrode of the first transistor are located in the second metal layer. The first active layer comprises a main body, a first protruding portion, and a second protruding portion. The first protruding portion and the second protruding portion are located on a side of the main body facing the second metal layer and contacting the main body. The first electrode is electrically connected to the first protruding portion through a first connection hole, and the second electrode is electrically connected to the second protruding portion through a second connection hole, which is conducive to simplifying the manufacturing process and reducing production costs.

## Description

### CROSS-REFERENCE TO RELATED APPLICATIONS

This application claims priority to Chinese Patent Application No. 202411788035.6, titled "DISPLAY PANEL, MANUFACTURING METHOD THEREOF, AND DISPLAY APPARATUS" and filed on December 5, 2024, which is hereby incorporated by reference in its entirety.

### TECHNICAL FIELD

The present disclosure relates to the field of display technology, and in particular to a display panel and a manufacturing method thereof, and a display apparatus.

### BACKGROUND

With the continuous advancement of science and technology, more and more display products, such as mobile phones, tablets, laptops, and smart wearable devices, are being widely used in people's daily lives and work, bringing tremendous convenience to daily lives and work, and becoming an indispensable tool for people today.

Currently, how to simplify the display product manufacturing process and reduce production costs has become one of the technical problems that need to be solved urgently.

### SUMMARY

To address the above-mentioned technical problems, the present disclosure provides a display panel, a manufacturing method thereof, and a display apparatus, aiming to simplify the manufacturing process and reduce production costs.

In a first aspect, the present disclosure provides a display panel comprising: a substrate and an array layer, the array layer is located on a side of the substrate and comprises a first semiconductor layer, a first metal layer, and a second metal layer, the first metal layer is located on a side of the first semiconductor layer facing away from the substrate, and the second metal layer is located on a side of the first metal layer facing away from the substrate;

the array layer comprises a first transistor, a first active layer of the first transistor is located in the first semiconductor layer, and a first electrode and a second electrode of the first transistor are located in the second metal layer; the first active layer comprises a main body, a first protruding portion, and a second protruding portion, the first protruding portion and the second protruding portion are located on a side of the main body facing the second metal layer and contact with the main body, the first electrode is electrically connected to the first protruding portion via a first connection hole, and the second electrode is electrically connected to the second protruding portion via a second connection hole.

In a second aspect, the present disclosure provides a method for manufacturing a display panel, comprising:
providing a substrate;
manufacturing a first sub-layer of a first semiconductor layer on a side of the substrate, and manufacturing a second sub-layer of the first semiconductor layer on a side of the first sub-layer facing away from the substrate;
removing at least parts of the first sub-layer and the second sub-layer to form a first active layer of a first transistor, the first active layer comprises a main body located in the first sub-layer and a first protruding portion and a second protruding portion located in the second sub-layer;
manufacturing a gate insulating layer on a side of the second sub-layer facing away from the substrate;
manufacturing a first metal layer on a side of the gate insulating layer facing away from the substrate, and forming a gate of a first transistor on the first metal layer;
manufacturing an interlayer insulating layer on the side of the first metal layer facing away from the substrate;
forming a first connection hole and a second connection hole in the interlayer insulating layer and the gate insulating layer, using the first protruding portion and the second protruding portion as alignment structures, so that the first connection hole exposes the first protruding portion, and the second connection hole exposes the second protruding portion;
manufacturing a second metal layer on the side of the interlayer insulating layer facing away from the substrate, forming a first electrode and a second electrode of the first transistor, so that the first electrode is electrically connected to the first protruding portion through the connection hole, and the second electrode is electrically connected to the second protruding portion through the connection hole.

In a third aspect, the present disclosure provides a display apparatus comprising the display panel provided in the first aspect of the present disclosure.

The technical solutions provided by the embodiments of the present disclosure have the following advantages over the prior art.

In the display panel, the manufacturing method thereof, and the display apparatus provided in the present disclosure, the first active layer of the first transistor in the array layer includes a main body and a first protruding portion and a second protruding portion located on the same side of the main body and contacting the main body. The first electrode and the second electrode of the first transistor are electrically connected to the first protruding portion and the second protruding portion through a first connection hole and a second connection hole, respectively. When the main body, the first protruding portion and the second protruding portion are introduced into the first active layer, the carrier concentration of the first protruding portion and the second protruding portion can be designed differently from that of the main body portion, so that the carrier concentration of the first protruding portion and the second protruding portion is higher than the carrier concentration of the main body. In this way, there is no need to introduce an ion implantation process to change the resistivity of the source and drain regions in the first active layer, thereby eliminating the ion implantation process in the production process and avoiding the increase in equipment investment required for the ion implantation process, which is conducive to simplifying the manufacturing process of display products and reducing production costs.

### BRIEF DESCRIPTION OF THE DRAWINGS

The drawings herein are incorporated into and constitute a part of this specification, which illustrate embodiments consistent with the present disclosure and, together with the description, serve to explain the principles of the present disclosure.

To more clearly illustrate the embodiments of the present disclosure or the technical solutions in the prior art, the following briefly describes the drawings required for use in the embodiments or the prior art descriptions. It is apparent that those skilled in the art can derive other drawings based on these drawings without inventive effort.
FIG. 1 is a schematic plan view of a display panel provided in an embodiment of the present disclosure;
FIG. 2 is an AA-axis cross-sectional view of the display panel in FIG. 1;
FIG. 3 is a schematic diagram of a connection between an array layer and a light-emitting element provided in an embodiment of the present disclosure;
FIG. 4 is another AA-axis cross-sectional view of the display panel in FIG. 1;
FIG. 5 is a top view of a first transistor in an embodiment of the present disclosure;
FIG. 6 is another AA-axis cross-sectional view of the display panel in FIG. 1;
FIG. 7 is a schematic structural diagram of a pixel driving circuit in a display panel provided in an embodiment of the present disclosure;
FIG. 8 is an operating timing diagram of the pixel driving circuit in FIG. 7 ;
FIG. 9 shows a schematic structural diagram of a driving transistor according to an embodiment of the present disclosure;
FIG. 10 shows a schematic structural diagram of a threshold compensation transistor or a first reset transistor according to an embodiment of the present disclosure;
FIG. 11 shows a top view corresponding to the first transistor in FIG. 10;
FIG. 12 shows another schematic structural diagram of a pixel driving circuit according to an embodiment of the present disclosure;
FIG. 13 shows another AA-axis cross-sectional view of the display panel in FIG. 1;
FIG. 14 shows a schematic diagram of a film layer forming a capacitor in a display panel according to related art;
FIG. 15 shows another AA-axis cross-sectional view of the display panel in FIG. 1;
FIG. 16 shows a connection diagram of the capacitor in FIG. 15;
FIG. 17 shows a flowchart of a method for manufacturing the display panel according to an embodiment of the present disclosure;
FIG. 18 shows a schematic structural diagram of manufacturing a first semiconductor layer in the method for manufacturing the display panel according to an embodiment of the present disclosure;
FIG. 19 shows a schematic structural diagram of forming a first protruding portion and a second protruding portion in the method for manufacturing the display panel according to an embodiment of the present disclosure;
FIG. 20 shows a schematic structural diagram of a gate insulating layer manufactured;
FIG. 21 shows a schematic structural diagram of a first metal layer manufactured;
FIG. 22 shows a schematic structural diagram of an interlayer insulating layer manufactured;
FIG. 23 shows a schematic structural diagram of a first connection hole and a second connection hole manufactured;
FIG. 24 shows a schematic structural diagram of a first electrode and a second electrode manufactured;
FIG. 25 shows a schematic diagram of the first protruding portion and the second protruding portion manufactured in the method for manufacturing the display panel provided by an embodiment of the present disclosure;
FIG. 26 shows another schematic diagram of the first protruding portion and the second protruding portion manufactured in the method for manufacturing the display panel provided by an embodiment of the present disclosure; and
FIG. 27 shows a schematic structural diagram of a display apparatus according to an embodiment of the present disclosure.

### DETAILED DESCRIPTION

To more clearly understand the above-mentioned objectives, features, and advantages of the present disclosure, the solution of present disclosure will be further described below. It should be noted that, in the absence of conflict, the embodiments of the present disclosure and the features therein may be combined with each other.

The following description sets forth many specific details to facilitate a full understanding of the present disclosure, but the present disclosure may also be implemented in other ways than those described herein. Apparently, the embodiments in the specification are only parts of the embodiments of the present disclosure, rather than all the embodiments.

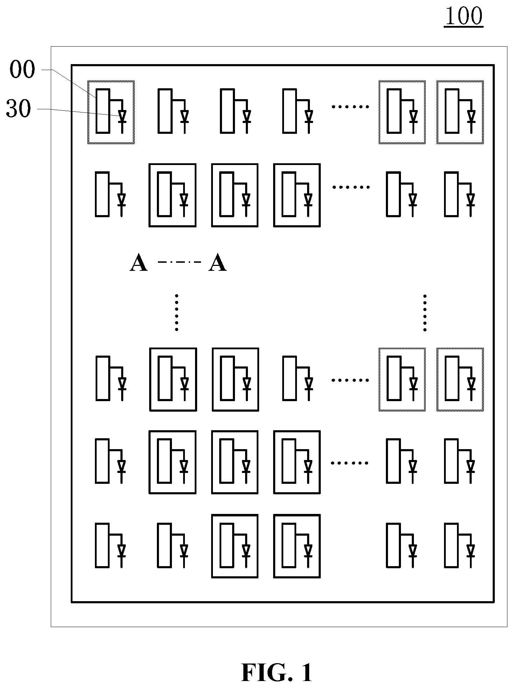

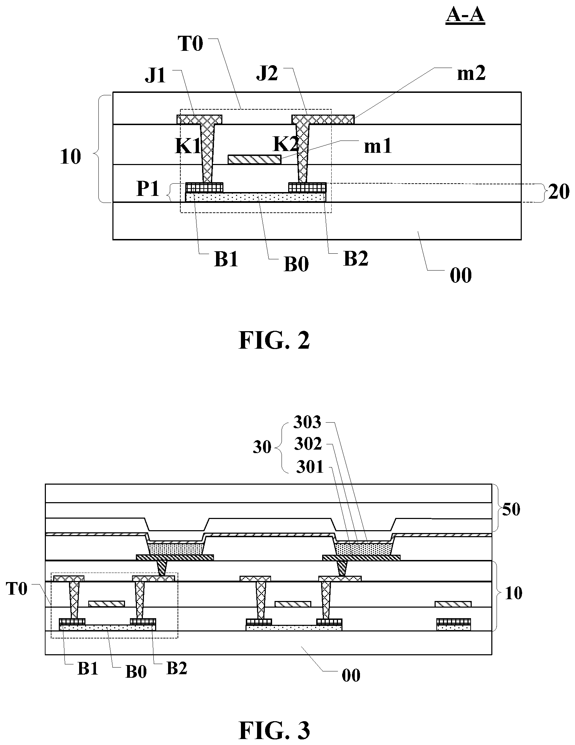

FIG. 1 is a schematic plan view of a display panel 100 provided by an embodiment of the present disclosure, and FIG. 2 shows an AA-axis cross-sectional view of the display panel 100 in FIG. 1. Referring to FIGS. 1 and 2, the embodiments of present disclosure provide a display panel 100 comprising a substrate 00 and an array layer 10. The array layer 10 is located on one side of the substrate 00. The array layer 10 includes a first semiconductor layer 20, a first metal layer m1, and a second metal layer m2. The first metal layer m1 is located on a side of the first semiconductor layer 20 facing away from the substrate 00, and the second metal layer m2 is located on a side of the first metal layer m1 facing away from the substrate 00.

The array layer 10 includes a first transistor T0. The first active layer P1 of the first transistor T0 is located in the first semiconductor layer 20. The first electrode J1 and the second electrode J2 of the first transistor T0 are located in the second metal layer m2. The first active layer P1 includes a main body B0, a first protruding portion B1, and a second protruding portion B2. The first protruding portion B1 and the second protruding portion B2 are located on the side of the main body B0 facing the second metal layer m2 and contact with the main body B0. The first electrode J1 is electrically connected to the first protruding portion B1 via a first connection hole K1, and the second electrode J2 is electrically connected to the second protruding portion B2 via a second connection hole K2.

It should be noted that FIG. 1 illustrates a rectangular display panel as an example and does not limit the actual shape of the display panel. In other embodiments of the present disclosure, the display panel may also be any other feasible shape, such as a circular or rounded rectangular shape. The embodiment of FIG. 1 illustrates the connection between the pixel driving circuit 00 and the light-emitting element 30 in the display panel, but does not limit the number and arrangement of the pixel driving circuits 00 and light-emitting elements 30 actually included in the display panel. Optionally, the display panel provided in this embodiment may be a display panel using organic light-emitting diode display technology, namely an OLED (Organic Light-Emitting Diode) display panel. For example, referring to FIG. 3, which shows a schematic diagram of a connection between the array layer 10 and the light-emitting element provided in an embodiment of the present application. This diagram differs from FIG. 2 in that FIG. 3 illustrates the connection between the array layer 10 and the light-emitting element. The display panel includes a light-emitting element 30 and an array layer 10 connected to the light-emitting element 30. This embodiment uses the light-emitting element 30 and a portion of the first transistor T0 in the array layer 10 as an example. The basic structure of the light-emitting element 30 of the OLED display panel includes an anode 301, a light-emitting material layer 302, and a cathode 303. When a power supply supplies an appropriate voltage, holes generated in the anode 301 and electrons generated in the cathode 303 combine in the light-emitting material layer 302, generating bright light. Compared to liquid crystal displays, OLED display panels offer high visibility and brightness, are more energy-efficient, lightweight, and thin. Optionally, an encapsulation layer 50 may be included on the side of the light-emitting element 30 facing away from the substrate 00 to encapsulate the light-emitting element. The encapsulation layer 50 may be a combination of organic and inorganic layers, but the present disclosure is not limited to this. In some other embodiments of the present disclosure, the display panel may also utilize inorganic light-emitting diode display technology, such as a Micro LED display panel or a Mini LED display panel, but the present disclosure is not limited to this.

It should also be noted that this embodiment uses the structure of the first transistor T0 included in the display panel as an example, and does not limit the structures of all transistors included in the display panel. In some other embodiments of the present disclosure, all transistors in the array layer 10 may have the structure shown in the first transistor T0. In some other embodiments of the present disclosure, some transistors in the array layer 10 may have the structure shown in the first transistor T0, while other transistors may have other structures, which is not specifically limited in the present disclosure.

Continuing to refer to FIGS. 2 and 3, the display panel provided in the embodiments of the present disclosure includes an array layer 10 comprising a first semiconductor layer 20 and a first metal layer m1 and a second metal layer m2 located on the same side of the first semiconductor layer 20. The first active layer P1 of the first transistor T0 may, for example, be located in the first semiconductor layer 20, the gate of the first transistor T0 may, for example, be located in the first metal layer m1, and the first electrode J1 and the second electrode J2 of the first transistor T0 may, for example, be located in the second metal layer m2.

In related art, when fabricating transistors in the array layer, after the active layer is fabricated, ion implantation equipment is typically introduced to implant ions into the source and drain regions of the active layer. This ion implantation alters the contact resistances of the source and drain regions of the active layer, thereby achieving an electrical connection between the source of the transistor and the source region of the active layer, and an electrical connection between the drain of the transistor and the drain region of the active layer. Given the high cost of ion implantation equipment, introducing ion implantation equipment into the manufacturing process of display products greatly increases the manufacturing cost of the display products.

In order to solve the above technical problems, the embodiments of the present disclosure improve the structure of the first active layer P1 of the first transistor T0. Referring to FIGS. 2 and 3 for details, the first active layer P1 includes a main body B0 and a first protruding portion B1 and a second protruding portion B2 located on the side of the main body B0 away from the substrate 00. The first protruding portion B1 and the second protruding portion B2 are in direct contact with the main body B0. The region where the first protruding portion B1 is located can be regarded as a source region of the first active layer P1, and the region where the second protruding portion B2 is located can be regarded as a drain region of the first active layer P1. In some other embodiments of the present disclosure, the region where the first protruding portion B1 is located can also be regarded as a drain region of the first active layer P1, and the region where the second protruding portion B2 is located can be regarded as a source region of the first active layer P1. When the first protruding portion B1 and the second protruding portion B2 are introduced into the source region and the drain region of the first active layer P1, the carrier concentrations of the first protruding portion B1 and the second protruding portion B2 can be differentiated from those of the main body B0. For example, the carrier concentrations of the first protruding portion B1 and the second protruding portion B2 can be increased, so that the first protruding portion B1 and the second protruding portion B2 have a good conductive effect, thereby respectively achieving electrical connection with the first electrode J1 and the second electrode J2 in the first transistor T0. In this way, the ion implantation process can be omitted, and there is no need to introduce ion implantation equipment into the manufacturing process of display panel, thereby avoiding the problems of increased production costs and complicated production processes caused by the introduction of ion implantation equipment for the ion implantation process. Therefore, it is conducive to simplifying the manufacturing process of display panel and reducing the production costs.

Optionally, the first transistor T0 in the embodiments of the present disclosure is an oxide transistor, and the corresponding first semiconductor layer 20 is an oxide semiconductor layer. When an oxide transistor is introduced into the array layer 10, the oxide transistor exhibits reduced leakage current, which improves the output accuracy of the circuit in which the oxide transistor is incorporated. In the first active layer P1, the main body B0, the first protruding portion B1, and the second protruding portion B2 all comprise oxide materials.

Referring to FIG. 2, in an optional embodiment of the present disclosure, in the first active layer P1 corresponding to the first transistor T0, the resistivity of the first protruding portion B1 and the second protruding portion B2 is smaller than that of the main body B0. In actual manufacturing process, the main body B0 can be made of conventional active layer materials, while the first protruding portion B1 and the second protruding portion B2 can be made of materials with a relatively small resistivity, which ensures that the first protruding portion B1 and the second protruding portion B2 have better conductivity, the connection between the first protruding portion B1 and the first electrode J1 and the connection between the second protruding portion B2 and the second electrode J2 can be achieved without introducing an ion implantation process to change the conductivity of the source region and the drain region of the first active layer P1, thereby simplifying the manufacturing process of the display panel and reducing production costs.

In the embodiments of the present disclosure, when the first protruding portion B1 and the second protruding portion B2 are introduced into the first active layer P1 to achieve electrical connection with the first electrode J1 and the second electrode J2, the carrier concentrations in the first protruding portion B1 and the second protruding portion B2 are higher than the carrier concentration in the main body B0. At this time, the main body B0 can use at least one of the semiconductor materials such as IGZO, IGZTO, IGO and IZTO, and the first protruding portion B1 and the second protruding portion B2 can use ITO, IZO or IGZO series materials with relatively high In content, thereby reducing the contact resistance between the first protruding portion B1 and the first electrode J1, and reducing the contact resistance between the second protruding portion B2 and the second electrode J2, thereby achieving reliable electrical connection between the first electrode J1 and the first protruding portion B1, and reliable electrical connection between the second electrode J2 and the second protruding portion B2.

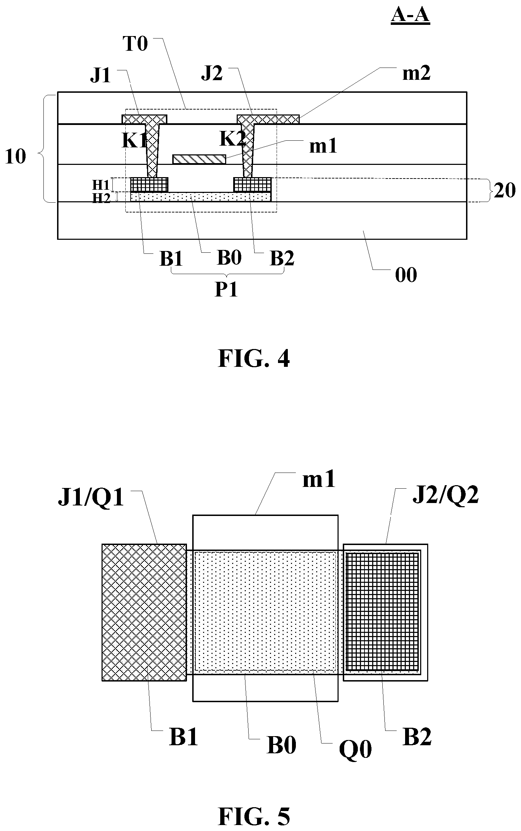

FIG. 4 shows another AA-axis cross-sectional view of the display panel shown in FIG. 1. Referring to FIGS. 2 and 4, in an optional embodiment of the present disclosure, the thickness of the first protruding portion B1 is greater than or equal to the thickness of the main body B0, and the thickness of the second protruding portion B2 is greater than or equal to the thickness of the main body B0.

Optionally, thickness of the first protruding portion B1 and the second protruding portion B2 are the same, which allows the first protruding portion B1 and the second protruding portion B2 to be manufactured using the same process dimensions, thereby simplifying the overall manufacturing process of display panel. The embodiment shown in FIG. 2 illustrates a solution where the thickness of the first protruding portion B1 and the second protruding portion B2 is equal to the thickness of the main body B0, while the embodiment shown in FIG. 4 illustrates a solution where the thickness of the first protruding portion B1 and the second protruding portion B2 is greater than the thickness of the main body B0. Within a certain thickness range, the greater the thickness of the first protruding portion B1 and the second protruding portion B2, the smaller the impedance of the first protruding portion B1 and the second protruding portion B2 will be. In this embodiment, when the thickness of the first protruding portion B1 and the second protruding portion B2 is greater than or equal to the thickness of the main body B0, it is conducive to reducing the impedance of the first protruding portion B1 and the second protruding portion B2, improving the electrical connection reliability between the first electrode J1 and the first protruding portion B1, and the electrical connection reliability between the second electrode J2 and the second protruding portion B2, in the first transistor T0.

Referring again to FIGS. 2 and 4, in an optional embodiment of the present disclosure, the thickness of the first protruding portion B1 and the second protruding portion B2 is H1, and the thickness of the main body B0 is H2, where H1 = (1 + k) × H2, where 0 ≤ k ≤ 20%.

Considering that when the main body B0, the first protruding portion B1 and the second protruding portion B2 are introduced into the first active layer P1, the thickness of the first protruding portion B1 and the second protruding portion B2 may affect the thickness of the display panel. If the k value is set to greater than 20%, the thickness of the first protruding portion B1 and the second protruding portion B2 may be relatively large, which may cause the first protruding portion B1 and the second protruding portion B2 to significantly affect the overall thickness of the display panel, hindering the thinning design of the display panel. However, when the k value is set to 20% or less, the overall thickness of the display panel can be controlled within a certain range after the first protruding portion B1 and the second protruding portion B2 are introduced, thereby avoiding a significant impact on the overall thickness of the display panel caused by the introduction of the first protruding portion B1 and the second protruding portion B2, and meeting the requirements for thinning of the display panel design.

In an optional embodiment of the present disclosure, the thickness of the main body B0 is 25nm≤H2≤30nm. Considering that the operation of transistors is based on the carrier behavior of semiconductors, the p-n structure formed between n-type and p-type semiconductors can control the flow of current. By varying the gate voltage to control the number of carriers, the current from source to drain can be controlled. Therefore, the main body B0 in the first transistor T0 needs to have a certain thickness to achieve this control process. If the thickness of the main body B0 is set to less than 25nm, it may affect the properties of the semiconductor in the first transistor T0. If the thickness of the main body B0 is set to greater than 30nm, it may have a certain impact on the overall thickness of the display panel. Therefore, in this embodiment, the thickness of the main body B0 is set to 25nm≤H2≤30nm, which not only ensures the properties of the semiconductor in the first transistor T0 but also helps meet the requirements of a thinner display panel. Optionally, 26nm≤H2≤29nm, or 25nm≤H2≤ 28nm, which is not specifically limited in the present disclosure.

Continuing to refer to FIGS. 2 to 4, in an optional embodiment of the present disclosure, along a direction perpendicular to the substrate 00, an orthographic projection of the first connection hole K1 on a plane where the substrate 00 is located is located within an orthographic projection of the first protruding portion B1 on the plane where the substrate 00 is located, and an orthographic projection of the second connection hole K2 on the plane where the substrate 00 is located is located within an orthographic projection of the second protruding portion B2 on the plane where the substrate 00 is located. In this way, when forming the first connection hole K1 and the second connection hole K2, the first protruding portion B1 and the second protruding portion B2 can be used as a reference. The first connection hole K1 is formed directly above the first protruding portion B1 to expose the first protruding portion B1, and the second connection hole K2 is formed directly above the second protruding portion B2 to expose the second protruding portion B2. No additional reference objects are required, which is conducive to simplifying the manufacturing process of the first connection hole K1 and the second connection hole K2. When forming the first electrode J1 and the second electrode J2, metal material is filled into the first connection hole K1 to achieve electrical connection between the first electrode J1 and the first protruding portion B1, and metal material is filled into the second connection hole K2 to achieve electrical connection between the second electrode J2 and the second protruding portion B2.

FIG. 5 shows a top view of the first transistor T0 in an embodiment of the present disclosure. Referring to FIG. 5, in an optional embodiment of the present disclosure, the first active layer P1 includes a channel region Q0 and first region Q1 and the second region Q2 located on both sides of the channel region Q0. The first protruding portion B1 is located in the first region Q1, and the second protruding portion B2 is located in the second region Q2. In a direction perpendicular to the plane where the substrate 00 is located, the first protruding portion B1 and the second protruding portion B2 do not overlap the channel region Q0.

For transistors in related art, their active layers include a channel region and doped regions located on both sides of the channel region. The ion doping concentration in the doped regions is different from that in the channel region, and ion doping in the doped regions is typically achieved through ion implantation. Referring to FIGS. 4 and 5, the process of forming doped regions can be omitted via ion implantation in the embodiments of present disclosure. In other words, ion implantation is not performed on the main body B0. Instead, a first protruding portion B1 and a second protruding portion B2 with a relatively high resistivity are introduced on the side of the main body B0 facing away from the substrate 00. The first region Q1 where the first protruding portion B1 is located and the second region Q2 where the second protruding portion B2 is located can be regarded as conductive regions of the first active layer P1, thereby achieving electrical connection with the first electrode J1 and the second electrode J2. Therefore, the introduction of the first protruding portion B1 and the second protruding portion B2 eliminates the process of doping the first active layer P1 through ion implantation process, which is conducive to simplifying the overall manufacturing process of the display panel and improving production efficiency.

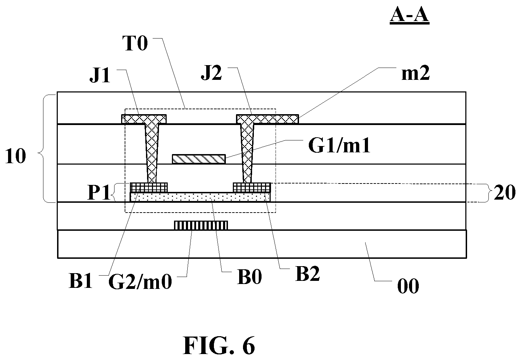

FIG. 6 shows another AA-axis cross-sectional view of the display panel shown in FIG. 1. This differs from the previous embodiments in that the first transistor T0 in the embodiment of FIG. 6 includes two gates, the first transistor T0 is a transistor with a dual-gate structure.

Referring to FIG. 6, in an optional embodiment of the present disclosure, the array layer 10 includes an auxiliary metal layer m0. The auxiliary metal layer m0 is located on the side of the first active layer P1 facing the substrate 00 and overlaps with the first active layer P1 in a direction perpendicular to the substrate 00. The gate of the first transistor T0 includes a first gate G1 and a second gate G2. The first gate G1 is located in the first metal layer m1, and the second gate G2 is located in the auxiliary metal layer m0. In the embodiments of the present disclosure, the auxiliary metal layer m0 is introduced on the side of the first active layer P1 facing the substrate 00 to form the second gate G2 of the first transistor T0. In a direction perpendicular to the plane where the substrate 00 is located, the first gate G1 and the second gate G2 each overlap with the first active layer P1 to respectively form channel regions, thereby forming a transistor having a dual-gate and dual-channel structure. This transistor structure increases the channel area of the first transistor T0, which is conducive to improving current transmission efficiency.

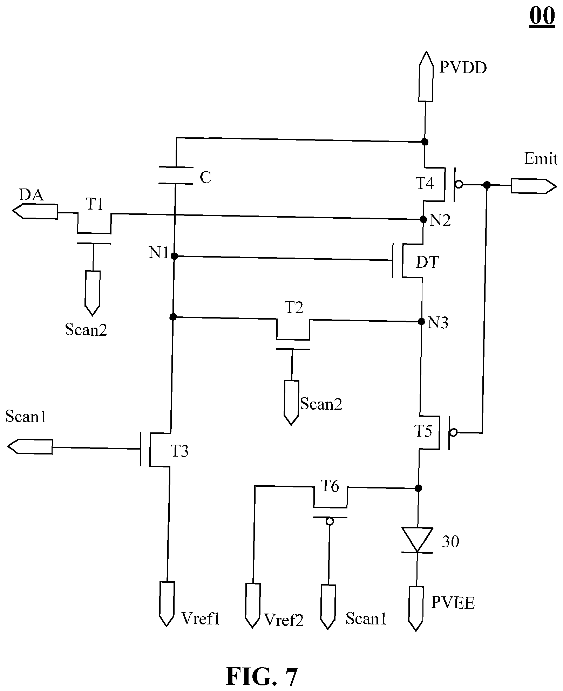

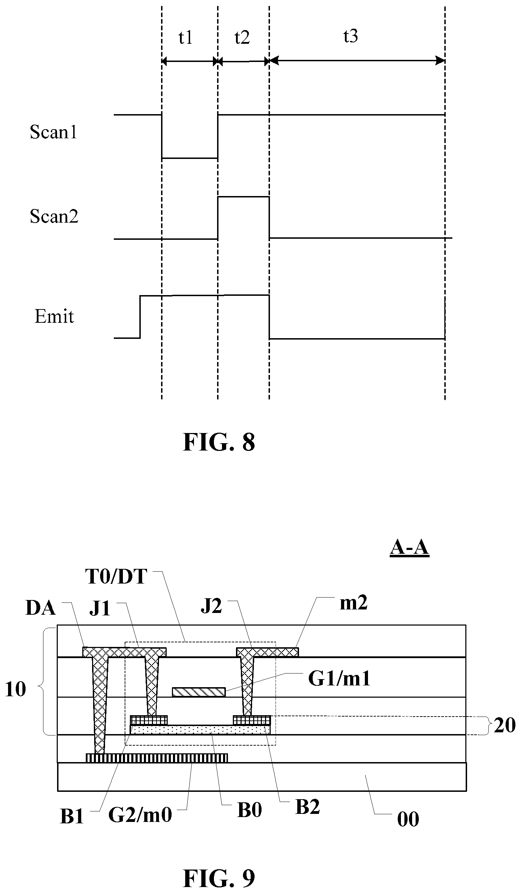

FIG. 7 is a schematic structural diagram of a pixel driving circuit in a display panel provided by an embodiment of the present disclosure, and FIG. 8 is an operating timing diagram of the pixel driving circuit in FIG. 7. Referring to FIGS. 1, 7, and 8, in an optional embodiment of the present disclosure, the display panel includes multiple pixel driving circuits 00, and the pixel driving circuit 00 includes a driving transistor DT, a data writing transistor T1, a threshold compensation transistor T2 and a first reset transistor T3, the gate of the driving transistor DT is connected to the first node N1, the first electrode is connected to the second node N2, and the second electrode is connected to the third node N3; the first electrode of the data writing transistor T1 is connected to the data line DA, and the second electrode is connected to the second node N2; the first electrode of the threshold compensation transistor T3 is connected to the third node N3, and the second electrode is connected to the second node N2; the first electrode of the first reset transistor T3 is connected to the first reset signal line Vref1, and the second electrode is connected to the first node N1; the first transistor T0 mentioned in the embodiments of the present disclosure includes at least one of the driving transistor DT, the threshold compensation transistor T2 or the first reset transistor T3. It should be noted that FIG. 7 only illustrates the example in which the first transistor T0 includes a driving transistor DT, a first reset transistor T3, a threshold compensation transistor T2 and a data writing transistor T1, but is not limited to this. In some other embodiments of the present disclosure, the first transistor T0 may include only one or any two of the driving transistor DT, the first reset transistor T3, and the threshold compensation transistor T2.

It should also be noted that the embodiment shown in FIG. 7 is illustrated by taking a pixel driving circuit including seven transistors merely for example, and does not limit the actual structure of the pixel driving circuit. Optionally, the pixel driving circuit 00 further includes two light-emitting control transistors T4 and T5 and a second reset transistor T6. One of the two light-emitting control transistors T4/T5 is connected between the power supply signal terminal PVDD and the second node N2, and the other is connected between the third node N3 and the anode of the light-emitting element 30. The cathode of the light-emitting element 30 is connected to the power supply signal terminal PVEE. The second reset transistor T6 is connected between the second reset signal line Vref2 and the anode of the light-emitting element 30. The control terminals of the first reset transistor T3 and the second reset transistor T6 are connected to the first control signal terminal Scan1, the control terminals of the data writing transistor T1 and the threshold compensation transistor T2 are connected to the second control signal terminal Scan2, and the control terminals of the light-emitting control transistors T4/T5 are connected to the light-emitting control signal terminal Emit. Optionally, the operating sequence of the pixel driving circuit 00 includes a reset phase t1, a data writing phase t2, and a light-emitting phase t3. The first reset transistor T3 and the second reset transistor T6 are turned on during the reset phase. The first reset transistor T3 is configured to reset the gate of the driving transistor, and the second reset transistor T6 is configured to reset the anode of the light-emitting element 30. The data writing transistor T1 and the threshold compensation transistor T2 are turned on during the data writing phase to write the data signal to the second node N2 and perform threshold compensation on the gate of the driving transistor DT. The light-emitting control transistors T4 and T5 are turned on during the light-emitting phase. During the light-emitting phase, the signal from the power supply signal terminal PVDD is transmitted to the driving transistor DT, which generates a driving current to drive the light-emitting element 30 to emit light. It should be noted that the above timing sequence is merely illustrative and is not limited by the present disclosure. In some other embodiments of the present disclosure, the driving timing sequence may be modified to some extent. For example, the second reset transistor may be turned on during the data writing phase, which is not limited by the present disclosure.

Considering that the driving transistor is a transistor configured to generate the driving current in the pixel driving circuit 00 and has high requirements for current transfer efficiency, in the case that the first transistor T0 includes the driving transistor DT, the driving transistor DT possesses the characteristics of the first transistor T0. In the case that the first transistor T0 is an oxide transistor or a dual-gate and dual-channel oxide transistor, the first transistor T0 has high mobility and current transfer efficiency, which is conducive to improving the driving efficiency of the light-emitting element. Furthermore, considering that both the first reset transistor T3 and the threshold compensation transistor T2 are transistors directly connected to the gate of the driving transistor, if one of the first reset transistor T3 and the threshold compensation transistor T2 has a large leakage current, it may have a significant impact on the gate potential of the driving transistor DT. Changes in the gate potential of the driving transistor DT may affect the magnitude of the driving current ultimately outputted, thereby affecting the light-emitting accuracy of the light-emitting element 30. If the first transistor T0 in the embodiments of the present disclosure includes at least one of the first reset transistor T3 and the threshold compensation transistor T2, since the first transistor T0 is an oxide transistor with low leakage current, it is conducive to reducing or avoiding the impact of the leakage current of the first reset transistor T3 or the threshold compensation transistor T2 on the gate potential of the driving transistor, thereby improving the output accuracy of the pixel driving circuit.

In the case that the first transistor T0 includes a driving transistor DT, and in the case that the first transistor T0 includes one of a threshold compensation transistor T2 or a first reset transistor T3, the connection relationship between the two gates of the first transistor T0 can be designed differently, as described in detail below.

FIG. 9 shows a schematic structural diagram of a driving transistor in an embodiment of the present disclosure. Referring to FIGS. 7 and 9, in an optional embodiment of the present disclosure, the first transistor T0 includes a driving transistor DT. The first gate G1 of the driving transistor DT is connected to the first node N1, and the second gate G2 of the driving transistor DT is connected to the data line DA. In the case that the driving transistor DT is a dual-gate and dual-channel transistor, its first gate G1 and second gate G2 can be connected to different potentials. Specifically, the first gate G1 is connected to the first node N1 in the pixel driving circuit 00, and the second gate G2 is connected to the data line DA in the display panel. Considering that the driving transistor is an oxide transistor, in the case that the driving transistor includes a first gate G1 and a second gate G2, if the first gate G1 and the second gate G2 are at the same potential, in the case that the driving transistor DT is in the on state for a long time, both the first gate G1 and the second gate G2 are subject to a positive bias electric field, resulting in gate stress, which may increases the threshold offset of the driving transistor DT and may affect the accuracy of the output current of the driving transistor. However, in this embodiment, in the case that the second gate G2 of the driving transistor DT is connected to the data line DA, the potential of the data line DA is generally low, and the second gate G2 may not generate a positive bias electric field. Only the first gate G1 generate a positive bias electric field. Compared to the method of equipotentially connecting the first gate G1 and the second gate G2, this method is conducive to reducing the threshold voltage offset of the driving transistor, thereby improving the accuracy of the driving current output by the driving transistor.

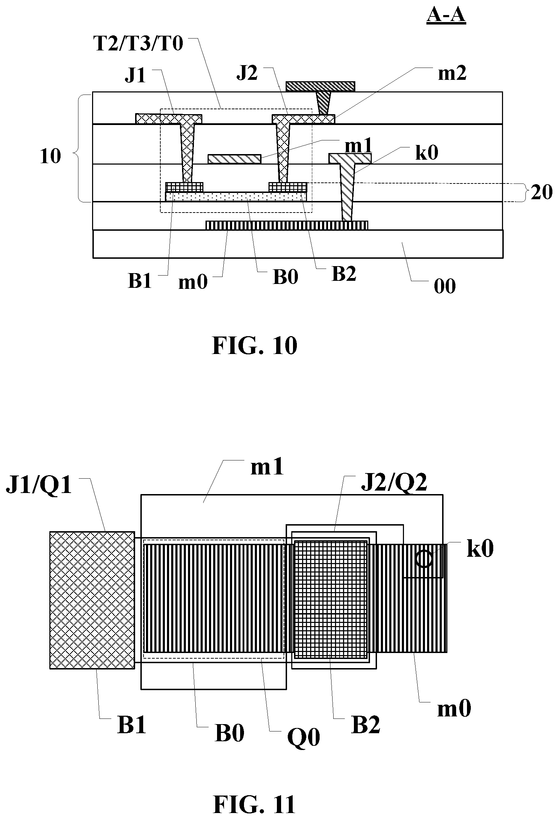

FIG. 10 shows a schematic structural diagram of a threshold compensation transistor or a first reset transistor in an embodiment of the present disclosure. FIG. 11 shows a top view corresponding to the first transistor T0 in FIG. 10. Referring to FIGS. 10 and 11, in an optional embodiment of the present disclosure, the first transistor T0 includes a threshold compensation transistor T2 and/or a first reset transistor T3. The first gate G1 and the second gate G2 of the threshold compensation transistor T2 and/or the first reset transistor T3 are electrically connected. Optionally, the first gate G1 and the second gate G2 are electrically connected via a connection hole k0.

Considering that both the threshold compensation transistor T2 and the first reset transistor T3 in the pixel driving circuit are switching transistors, the two are turned on only during specific periods. For example, the threshold compensation transistor T2 is turned on in the case that performing threshold compensation on the gate of the driving transistor DT, and the first reset transistor T3 is turned on in the case that resetting the gate of the driving transistor DT. Therefore, either of the threshold compensation transistor T2 and the first reset transistor T3 does not need to be turned on for a long period of time. In the case that the first transistor T0 includes this type of transistor, in this embodiment, its first gate G1 and second gate G2 are electrically connected, so that the first gate G1 and the second gate G2 are at the same potential, which is conducive to increasing the mobility and on-state current of this type of transistor, ensuring that the transistor turns on quickly in the case that needed, thereby improving the response speed of the pixel driving circuit.

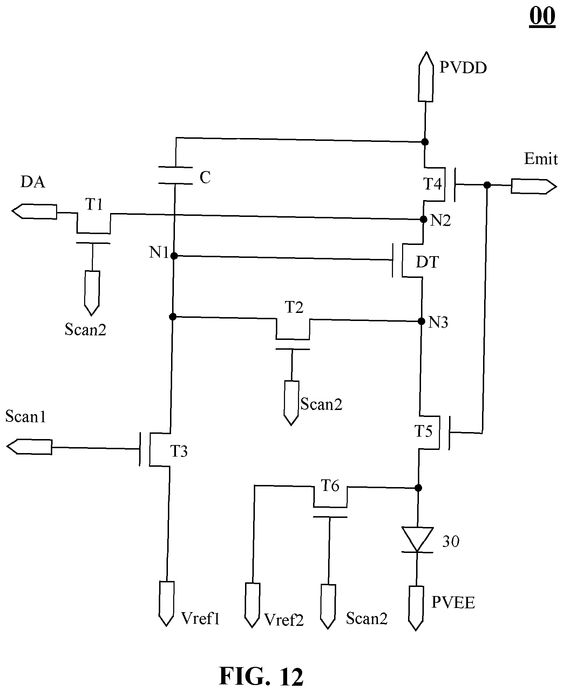

FIG. 12 shows another schematic structural diagram of a pixel driving circuit provided by an embodiment of the present disclosure. The difference from FIG. 7 is that each transistor in the pixel driving circuit shown in FIG. 12 embodies the structure of the first transistor T0 mentioned in the embodiment of the present disclosure.

Referring to FIG. 12, in an optional embodiment of the present disclosure, the pixel driving circuit further includes a first switch control transistor T4 and a second switch control transistor T5. The first electrode J1 of the first switch control transistor T4 is connected to the power supply signal terminal PVDD, and the second electrode J2 is connected to the second node N2. The first electrode J1 of the second switch control transistor T5 is connected to the third node N3, and the second electrode J2 is connected to the light-emitting element 30. The first transistor T0 includes the first switch control transistor T4 and the second switch control transistor T5.

The first switch control transistor T4 and the second switch control transistor T5 are configured to be turned on during the light-emitting phase, thereby forming a current path between the power supply signal terminal PVDD and the light-emitting element 30, and transmitting the driving current generated by the driving transistor DT to the light-emitting element 30. The first switch control transistor T4 and the second switch control transistor T5 are both switching transistors. In the case that the first transistor T0 includes the first switch control transistor T4 and the second switch control transistor T5, the structure shown in FIG. 10 can be adopted. It is conducive to increasing the mobility and on-state current of this type of transistor, ensuring that the transistor is turned on quickly in the case that needed, thereby improving the response speed of the pixel driving circuit.

In the case that all transistors in the pixel driving circuit of the embodiments in the present disclosure are first transistors, that is, oxide transistors, each transistor in the pixel driving circuit is a high-mobility transistor and has the characteristics of low leakage current. At the same time, the transistors in the display region achieve structural uniformity over a large area, which is conducive to achieving low power consumption and good display uniformity. In addition, in the case that the transistors in the pixel driving circuit are all embodied as oxide transistors, the manufacturing process is simplified compared to the method of doping other types of transistors, which is conducive to reducing overall production costs.

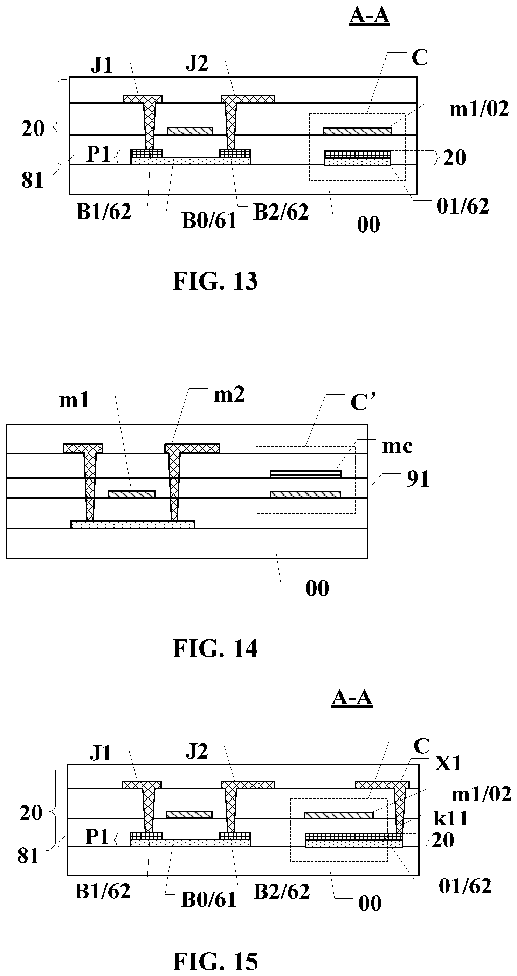

FIG. 13 shows another AA-axis cross-sectional view of the display panel shown in FIG. 1. Referring to FIG. 13, in an optional embodiment of the present disclosure, the first semiconductor layer 20 includes a first sub-layer 61 and a second sub-layer 62. The electrical resistivity of the second sub-layer 62 is smaller than that of the first sub-layer 61, the main body B0 is located in the first sub-layer 61, a and the first protruding portion B1 and the second protruding portion B2 are located in the second sub-layer 62; the array layer 10 also includes at least one capacitor C, the first electrode plate 01 of the capacitor C is at least located in the second sub-layer 62, and the second electrode plate 02 of the capacitor C is at least located in the first metal layer m1.

FIG. 14 is a schematic diagram of a film layer for forming a capacitor C in a display panel in the related art. Referring to FIG. 14, in the related art, a capacitor metal layer mc is introduced between the first metal layer m1 and the second metal layer m2, wherein the capacitor metal layer mc is separated from the first metal layer m1 by an insulating isolation layer 91. At this time, the two electrode plates of the capacitor C are located on the capacitor metal layer mc and the first metal layer m1, respectively. It can be seen that in the case that the capacitor metal layer mc is added to form the capacitor C structure, the insulating isolation layer 91 is added accordingly, which increases the number of manufacturing processes and required masks. Referring to FIG. 13, in the case that the first semiconductor layer 20 is introduced into the display panel in the embodiments of the present disclosure, since a second sub-layer 62 with a relatively small resistivity is introduced into the first semiconductor layer 20, the second sub-layer 62 can be used to arrange the second protruding portion B2. In addition, the second sub-layer 62 can also be used as an electrode plate of the capacitor C, so that the second sub-layer 62 forms a capacitor structure with the other electrode plate located on the first metal layer m1, which eliminates the need for additional capacitor metal layer mc and insulating isolation layer 91 in the display panel, and is conducive to simplifying the overall panel structure and eliminating the masking process required to fabricate the capacitor metal layer mc and insulating isolation layer 91, thereby simplifying the overall manufacturing process of display panel.

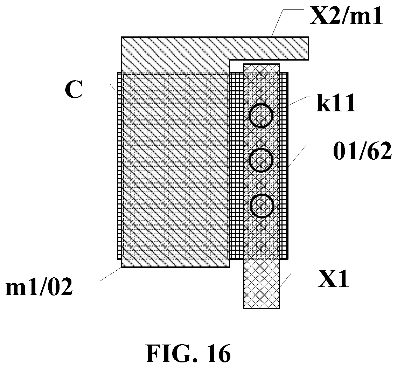

FIG. 15 shows another AA-axis cross-sectional view of the display panel in FIG. 1, and FIG. 16 shows a connection diagram of the capacitor C in FIG. 15. Referring to FIGS. 15 and 16 , in an optional embodiment of the present disclosure, the array layer 10 includes a first signal line X1 provided on a different layer from the first electrode plate 01, with the first electrode plate 01 electrically connected to the first signal line X1 via a connection hole k11; the array layer 10 includes a second signal line X2 provided on a same layer as the second electrode plate 02, with the second electrode plate 02 electrically connected to the second signal line X2. To form a capacitor C, it is necessary to provide electrical signals to the first electrode plate 01 and the second electrode plate 02 of the capacitor C respectively. In this embodiment, the first electrode plate 01 of the capacitor C is electrically connected to the first signal line X1, and the electrical signal is obtained through the first signal line X1, and the second electrode plate 02 of the capacitor C is electrically connected to the second signal line X2, and the electrical signal is obtained through the second signal line X2. Optionally, in the display panel, the material of the first metal layer m1 is mainly Mo, and the material of the second metal layer m2 is Ti-Al-Ti. Due to the characteristics of the materials themselves, the impedance of the first metal layer m1 is greater than the impedance of the second metal layer m2, that is, the resistivity of the first metal layer m1 is greater than the resistivity of the second metal layer m2, and the conductive effect of the second metal layer m2 is better than the conductive effect of the first metal layer m1. In the embodiments of the present disclosure, the first signal line X1 connected to the first electrode plate 01 can be provided in the second metal layer m2. In the case that the first signal line X1 is used to provide an electrical signal to the first electrode plate 01, it is conducive to improving the transmission efficiency of the electrical signal. The first electrode plate 01 and the first signal line X1 can be electrically connected by punching. It should be noted that this embodiment uses the example of disposing the first signal line X1 in the second metal layer m2 as an example, which is not a limited in the present disclosure. In other embodiments of the present disclosure, the first signal line X1 can also be provided in other feasible metal film layers. Furthermore, since the second electrode plate 02 of the capacitor C is located in the first metal layer m1, in the case that the second signal line X2 electrically connected to the second electrode plate 02 is provided in the first metal layer m1, the two can be electrically connected without punching, which is conducive to simplifying the manufacturing process.

Continuing to refer to FIGS. 13 and 15, in an optional embodiment of the present disclosure, the first metal layer m1 and the first semiconductor layer 20 are separated by a gate insulating layer 81 in a direction perpendicular to the plane where the substrate 00 is located. Compared to the structure of the related art shown in FIG. 14, in the embodiment of the present disclosure, the first electrode plate 01 of capacitor C is disclosed in the second sub-layer 62 of the first semiconductor layer 20, eliminating the insulating isolation layer 91 on the side of the first metal layer m1 facing away from the substrate 00, so that only one gate insulating layer 81 is included between the first metal layer m1 and the first semiconductor layer 20, which is conducive to reducing the distance between the first metal layer m1 and the first semiconductor layer 20, that is, it is conducive to reducing the distance between the two electrode plates of the capacitor C, thereby simplifying the film layer of the display panel while increasing the capacity of the capacitor C.

Continuing to refer to FIGS. 13 and 15, in an optional embodiment of the present disclosure, no other metal layers are located between the first metal layer m1 and the second metal layer m2 in a direction perpendicular to the plane where the substrate 00 is located. Compared to the structure of the related art shown in FIG. 14, in the embodiments of the present disclosure, the first electrode plate 01 and the second electrode plate 02 of the capacitor C are provided on the first semiconductor layer 20 and the first metal layer m1, respectively, which eliminates the need for a capacitor metal layer mc between the first metal layer m1 and the second metal layer m2, and is conducive to simplifying the metal film layers in the display panel, reducing masking steps, and simplifying the overall panel manufacturing process, thereby reducing production costs.

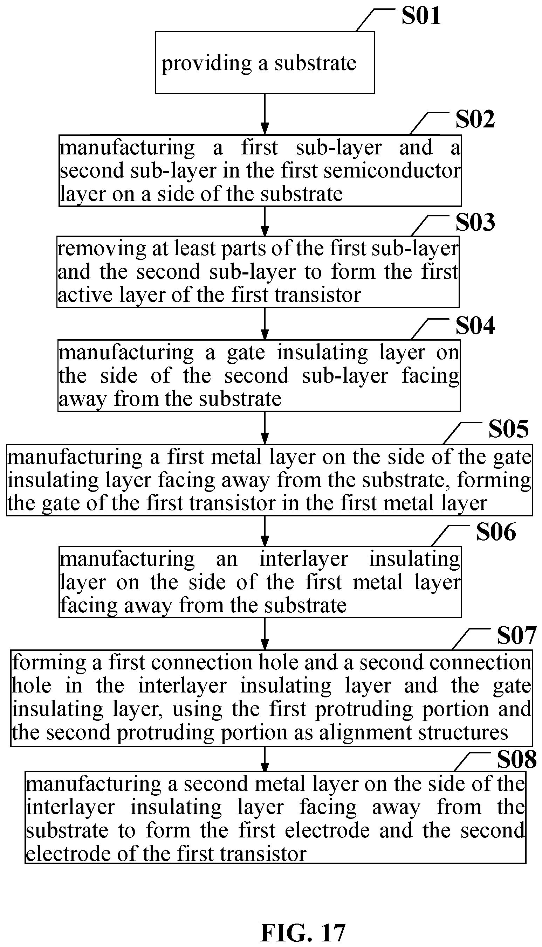

FIG. 17 shows a flowchart of a method for manufacturing a display panel provided by an embodiment of the present disclosure. Based on the same inventive concept, the present disclosure also provides a method for manufacturing the display panel, comprising: S01, S02, S03, S04, S05, S06, S07, and S08.

In S01, a substrate 00 is provided.

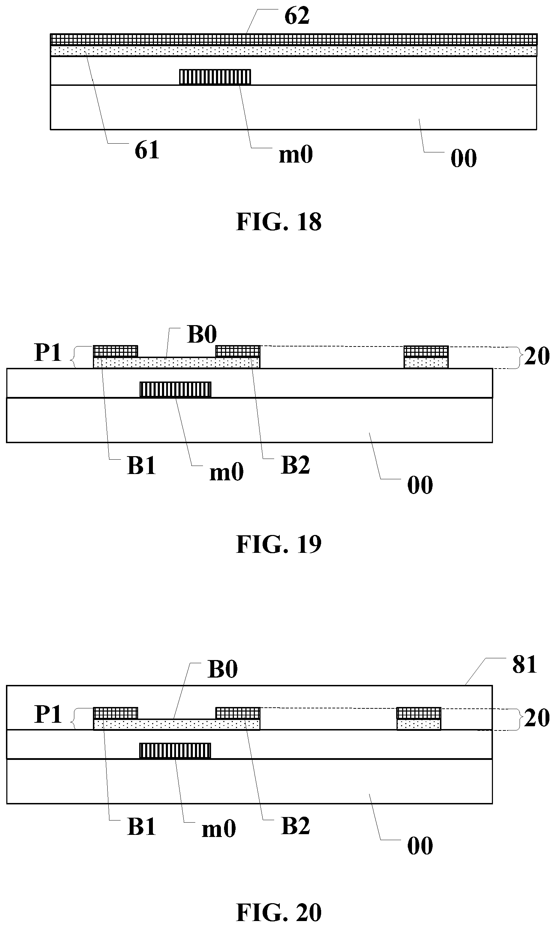

In S02, referring to FIG. 18, a first sub-layer 61 of the first semiconductor layer 20 is manufactured on one side of the substrate 00, and a second sub-layer 62 of the first semiconductor layer 20 is manufactured on one side of the first sub-layer 61 facing away from the substrate 00. FIG. 18 is a schematic structural diagram of a first semiconductor layer 20 manufactured by a method for manufacturing a display panel provided in an embodiment of the present disclosure. It should be noted that in the case that the display panel includes an auxiliary metal layer m0, the step of manufacturing the auxiliary metal layer m0 on the substrate 00 is also included before manufacturing the first semiconductor layer 20.

In S03, referring to FIG. 19, at least parts of the first sub-layer 61 and the second sub-layer 62 are removed to form the first active layer P1 of the first transistor T0. The first active layer P1 includes a main body B0 located in the first sub-layer 61 and a first protruding portion B1 and a second protruding portion B2 located in the second sub-layer 62. FIG. 19 shows a schematic structural diagram of the first protruding portion B1 and the second protruding portion B2 formed in the method for manufacturing a display panel provided by an embodiment of the present disclosure. The resistivity of the first protruding portion B1 and the second protruding portion B2 is smaller than that of the main body B0.

In S04, referring to FIG. 20, a gate insulating layer 81 is manufactured on the side of the second sub-layer 62 facing away from the substrate 00. FIG. 20 illustrates a schematic structural diagram of the gate insulating layer 81 manufactured.

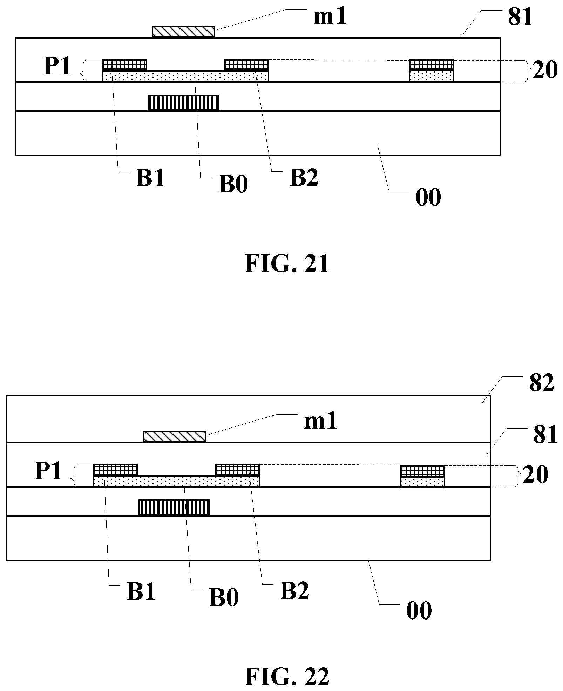

In S05, referring to FIG. 21, a first metal layer m1 is manufactured on the side of the gate insulating layer 81 facing away from the substrate 00. The gate of the first transistor T0 is formed in the first metal layer m1. FIG. 21 illustrates a schematic structural diagram of the first metal layer m1 manufactured.

In S06, referring to FIG. 22, an interlayer insulating layer 82 is manufactured on the side of the first metal layer m1 facing away from the substrate 00. FIG. 22 illustrates a schematic structural diagram of the interlayer insulating layer 82 manufactured.

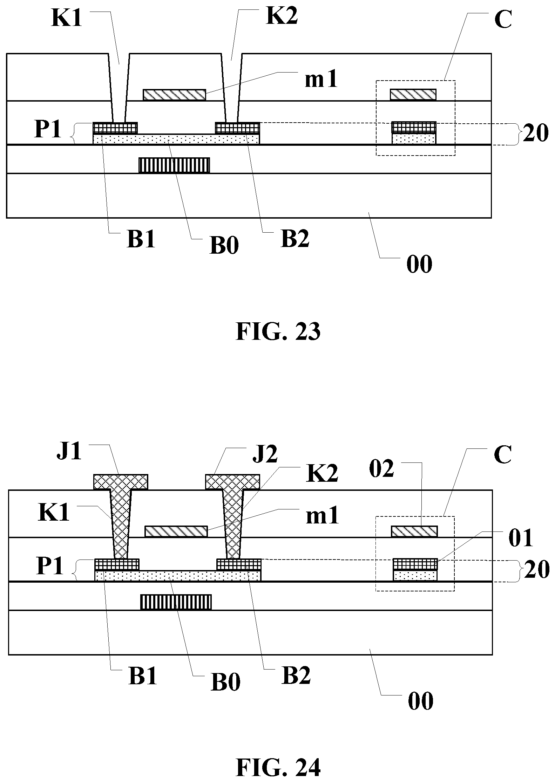

In S07, referring to FIG. 23, a first connection hole K1 and a second connection hole K2 are formed in the interlayer insulating layer 82 and the gate insulating layer 81, using the first protruding portion B1 and the second protruding portion B2 as alignment structures. The first connection hole K1 exposes the first protruding portion B1, and the second connection hole K2 exposes the second protruding portion B2. FIG. 23 illustrates a schematic structural diagram of the first connection hole K1 and the second connection hole K2 manufactured. In this way, taking the first protruding portion B1 and the second protruding portion B2 as references, a first connection hole K1 is formed directly above the first protruding portion B1 to expose the first protruding portion B1, and a second connection hole K2 is formed directly above the second protruding portion B2 to expose the second protruding portion B2. There is no need to introduce other reference objects, which is conducive to simplifying the manufacturing process of the first connection hole K1 and the second connection hole K2.

In S08, referring to FIG. 24, a second metal layer m2 is manufactured on the side of the interlayer insulating layer facing away from the substrate 00 to form the first electrode J1 and the second electrode J2 of the first transistor T0, so that the first electrode J1 is electrically connected to the first protruding portion B1 through a connection hole, and the second electrode J2 is electrically connected to the second protruding portion B2 through a connection hole. FIG. 24 shows a schematic structural diagram of the first electrode J1 and the second electrode J2 manufactured.

It should be noted that after the fabrication of the first electrode J1 and the second electrode J2, other required film layers may be manufactured on the side of the first electrode J1 and the second electrode J2 facing away from the substrate 00 as needed, which is not specifically limited in the present disclosure.

In the method for manufacturing the display panel provided in the embodiments of the present disclosure, during the fabrication of the first semiconductor layer 20, a first sub-layer 61 and a second sub-layer 62 are formed. The resistivity of the second sub-layer 62 is smaller than that of the first sub-layer 61. The main body B0 of the first active layer P1 of the first transistor T0 is formed on the first sub-layer 61, and a first protruding portion B1 and a second protruding portion B2 are formed on the second sub-layer 62, so that the first protruding portion B1 and the second protruding portion B2 have conductive properties. After the first metal layer m1 and the interlayer insulating layer 82 are subsequently fabricated, the first protruding portion B1 and the second protruding portion B2 can be used as references to manufacture the first connection hole K1 and the second connection hole K2. The first connection hole K1 exposes the first protruding portion B1, and the second connection hole K2 exposes the second protruding portion B2, which facilitates the subsequent electrical connection between the first electrode J1 and the first protruding portion B1, and the subsequent electrical connection between the second electrode J2 and the second protruding portion B2. As can be seen, in the embodiments of the present disclosure, a second sub-layer 62 with a relatively small resistivity is introduced during the fabrication of the first semiconductor layer 20, so that the first protruding portion B1 and the second protruding portion B2 located in the second sub-layer 62 have conductive properties, which eliminates the need for ion implantation to alter the resistivity of the source and drain regions in the first active layer P1, thereby eliminating the need for ion implantation during production and avoiding the increased investment in equipment required for ion implantation process, simplifying the display product manufacturing process, and reducing production costs.

In an optional embodiment of the present disclosure, in step S02, the first sub-layer 61 and the second sub-layer 62 are formed continuously in the same vacuum film-forming chamber. That is to say, after the first sub-layer 61 is formed in the pinhole film-forming chamber, there is no need to take out the semi-finished product that has been formed, but the second sub-layer 62 is continued to be manufactured on the first sub-layer 61. This method avoids the process of taking out the semi-finished product and then performing other operations, which is conducive to simplifying the overall production process of the display panel and improving production efficiency.

In an optional embodiment of the present disclosure, in step S02, during a fabrication of the second sub-layer 62, the film-forming parameters of the vacuum film-forming chamber are adjusted, so that an *In* content during a fabrication of the second sub-layer 62 is higher than an *In* content during a fabrication of the first sub-layer 61. In this way, the first sub-layer 61 and the second sub-layer 62 can be continuously manufactured in the same vacuum chamber, simply by adjusting the film-forming parameters without taking out the semi-finished product, thereby simplifying the manufacturing process. In addition, increasing the *In* content in the case that the second sub-layer 62 is manufactured can reduce the resistivity of the second sub-layer 62, and improve the conductivity of the second sub-layer 62, so that the second sub-layer 62 has the conductive properties, the conductive effect of the second sub-layer 62 can be achieved without introducing ion implantation equipment and ion implantation processes, which effectively saves production costs, simplifies the production process, and improves production efficiency.

Continuing to refer to FIGS. 18 to 24, in an optional embodiment of the present disclosure, while forming the first active layer P1 of the first transistor T0, the first sub-layer 61 and the second sub-layer are also used to form the first electrode plate 01 of the capacitor C; while forming the gate of the first transistor T0 in the first metal layer m1, the first metal layer m1 is also used to form the second electrode plate 02 of the capacitor C; along the direction perpendicular to the plane where the substrate 00 is located, the first electrode plate 01 overlaps with the second electrode plate 02. In the process of manufacturing the first semiconductor layer 20 in the embodiments of the present disclosure, in addition to forming the first active layer P1 of the first transistor T0, the first electrode plate 01 of the capacitor C is formed together with the first sub-layer 61 and the second sub-layer 62. The electrical signal can be provided to the first electrode plate 01 of the capacitor C by providing an electrical signal to the second sub-layer 62 with a conductive function. In the case that the first metal layer m1 is subsequently manufactured, the second electrode plate 02 of the capacitor C is formed together. In this way, the capacitor C can be manufactured without introducing additional production steps or masks into the display panel, thereby further simplifying the film structure of display panel, simplifying the production process, improving production efficiency, and reducing production costs.

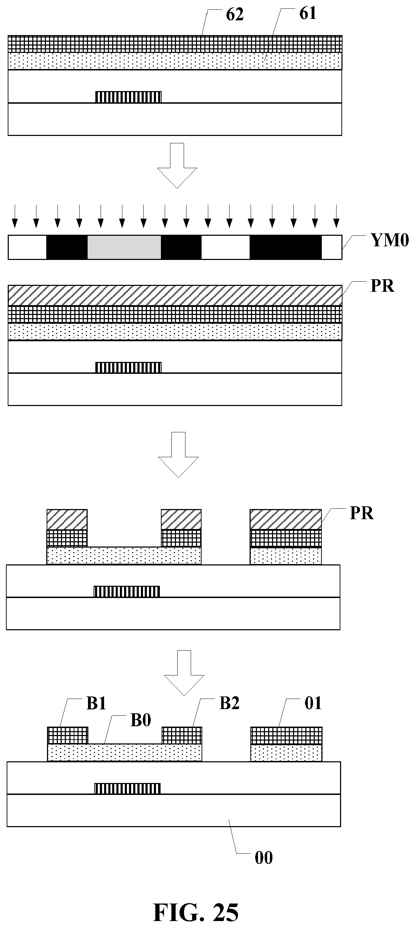

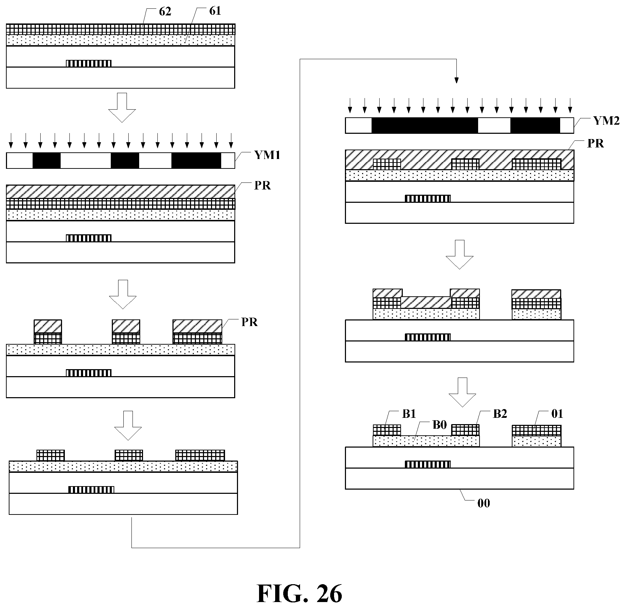

FIG. 25 shows a schematic diagram of the first protruding portion B1 and the second protruding portion B2 manufactured in the method for manufacturing the display panel provided by an embodiment of the present disclosure. FIG. 26 shows another schematic diagram of the first protruding portion B1 and the second protruding portion B2 manufactured in the method for manufacturing the display panel provided by an embodiment of the present disclosure. In an optional embodiment of the present disclosure, in step S03, at least parts of the first sub-layer 61 and the second sub-layer 62 are removed by a single half-tone mask process, as shown in FIG. 25, or by two separate mask processes, as shown in FIG. 26.

Referring to FIG. 25, after forming the first sub-layer 61 and the second sub-layer 62, a photoresist PR is introduced on the side of the second sub-layer 62 facing away from the substrate 00. A half-tone mask YM0 is also introduced on the side of the photoresist facing away from the substrate 00 for exposure. The half-tone mask YM0 has different transmittances in different regions. For example, the transmittance in the channel region is low (e.g., 50% to 60%) to ensure that the second sub-layer 62 in the channel region Q0 is completely etched, while the first sub-layer 61 in the channel region Q0 is retained. For the source and drain regions on the left and right sides of the channel, as well as the capacitor region, the mask has a transmittance of 0%, retaining the first sub-layer 61 and the second sub-layer 62. The transmittance of the remaining region of the mask is 100%, ensuring that the first sub-layer 61 and the second sub-layer 62 are completely removed from other regions. Following the exposure process, the photoresist is developed, and the sub-layers to be removed are removed using a wet etch process. The photoresist is then stripped to form the required main body B0, first protruding portion B1, second protruding portion B2, and first electrode plate 01 of capacitor. Using a half-tone mask process, only a single etching process is required to form the required structure, which is conducive to simplifying the overall display panel manufacturing process.

In addition to using a half-tone mask process, a conventional mask process can also be used to form the first protruding portion B1 and second protruding portion B2. For example, referring to FIG. 26, a photoresist PR is formed on the side of the second sub-layer 62 facing away from the substrate 00. A first conventional mask YM1 is then introduced on the side of the photoresist PR facing away from the substrate 00 for exposure. The first conventional mask YM1 includes only opaque and fully transparent regions. After the exposure process, the photoresist is developed. The second sub-layer 62 in other regions except the source region, the drain region and the capacitor region is removed by a wet etching process, and only the second sub-layer 62 in the source region, the drain region and the capacitor region is retained, and then the photoresist is stripped. Then, a full-surface photoresist PR is formed on the side of the second sub-layer 62 facing away from the substrate 00, and a second conventional mask YM2 is introduced for exposure. Similarly, the second conventional mask YM2 includes only fully transparent regions and opaque regions. After the exposure process, the photoresist is developed, the first sub-layer 61 in other regions except the channel region, the source region, the drain region and the capacitor region is removed by a wet etching process, and the first sub-layer 61 in the channel region, the source region, the drain region and the capacitor region is retained, and then the photoresist is stripped, thereby forming the required main body B0, first protruding portion B1, second protruding portion B2, and the first electrode plate 01 of the capacitor C. Using this process, two conventional masks are introduced, and the structure required by the embodiments of the present disclosure can also be formed, which is not specifically limited in the present disclosure.

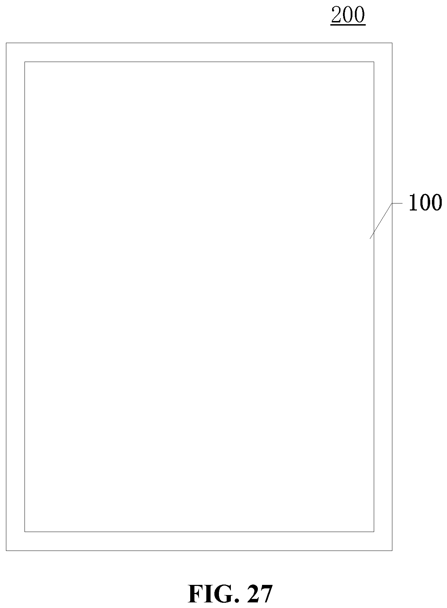

Based on the same inventive concept, the present disclosure also provides a display apparatus. FIG. 27 shows a schematic structural diagram of a display apparatus provided in an embodiment of the present disclosure. Referring to FIG. 27, the display apparatus 200 includes the display panel 100 described in any one of the aforementioned embodiments. The display apparatus 200 provided in the embodiments of the present disclosure can be any electronic device with a display function, such as a tablet computer, a display product in a display cabinet, a television, or an in-vehicle display apparatus. The display apparatus 200 provided in the embodiments of the present disclosure has the beneficial effects of the display panel 100 provided in the embodiments of the present disclosure. For details, refer to the detailed description of the display panel 100 in the aforementioned embodiments, which is not further specially described in this embodiment.

It should be understood that FIG. 27 illustrates only the display apparatus in a rectangular configuration. In some other embodiments of the present disclosure, the display apparatus 200 may also be circular, elliptical, or any other feasible shape, which is not specifically limited in the present disclosure.

It should be noted that, in the present disclosure, relational terms such as "first" and "second" are used solely to distinguish one entity or operation from another entity or operation, and do not necessarily require or imply any actual relationship or order between these entities or operations. Furthermore, the terms "comprise," "include," or any other variations thereof are intended to encompass a non-exclusive inclusion, such that a process, method, article, or device that includes a list of elements includes not only those elements but also other elements not expressly listed, or elements inherent to such process, method, article, or apparatus. Without further limitation, the phrase "comprises a..." does not preclude the presence of additional identical elements in the process, method, article, or device that includes the recited elements.

The foregoing description is intended to provide only specific embodiments of the present disclosure, intended to enable those skilled in the art to understand and implement the present disclosure. Various modifications to these embodiments will be readily apparent to those skilled in the art, and the general principles defined herein may be implemented in other embodiments without departing from the gist or scope of the present disclosure. Therefore, the present disclosure is not to be limited to the embodiments described herein but is to be accorded the widest scope consistent with the principles and novel features disclosed herein.

## Claims

1. A display panel, comprising a substrate and an array layer, wherein
the array layer is located on a side of the substrate and comprises a first semiconductor layer, a first metal layer, and a second metal layer, the first metal layer being located on a side of the first semiconductor layer facing away from the substrate, and the second metal layer being located on a side of the first metal layer facing away from the substrate; and
the array layer comprises a first transistor, a first active layer of the first transistor being located in the first semiconductor layer, and a first electrode and a second electrode of the first transistor being located in the second metal layer, the first active layer comprising a main body, a first protruding portion, and a second protruding portion, the first protruding portion and the second protruding portion being located on a side of the main body facing the second metal layer and contacting with the main body, the first electrode being electrically connected to the first protruding portion via a first connection hole, and the second electrode being electrically connected to the second protruding portion via a second connection hole.

2. The display panel according to claim 1, wherein an electrical resistivity of each of the first protruding portion and the second protruding portion is less than an electrical resistivity of the main body.

3. The display panel according to claim 1, wherein a thickness of the first protruding portion is greater than or equal to a thickness of the main body, and a thickness of the second protruding portion is greater than or equal to the thickness of the main body.

4. The display panel according to claim 3, wherein the thickness of each of the first protruding portion and the second protruding portion is H1, and the thickness of the main body is H2, where H1 = (1 + k) × H2, where 0 ≤ k ≤ 20%.

5. The display panel according to claim 4, wherein the thickness of the main body is 25 nm ≤ H2 ≤ 30 nm.

6. The display panel according to claim 1, wherein, along a direction perpendicular to the substrate, an orthographic projection of the first connection hole on a plane where the substrate is located is located within an orthographic projection of the first protruding portion on the plane where the substrate is located, and an orthographic projection of the second connection hole on the plane where the substrate is located is located within an orthographic projection of the second protruding portion on the plane where the substrate is located.

7. The display panel according to claim 1, wherein
the first active layer comprises a channel region and a first region and a second region located on two sides of the channel region,
the first protruding portion is located in the first region, and the second protruding portion is located in the second region, and
along a direction perpendicular to the substrate, either of the first protruding portion and the second protruding portion does not overlap with the channel region.

8. The display panel according to claim 1, wherein the first protruding portion and the second protruding portion comprise at least one of ITO, IZO, or IGZO; and the main body comprises at least one of IGZO, IGZTO, IGO, or IZTO.

9. The display panel according to claim 1, wherein the array layer comprises an auxiliary metal layer located on a side of the first active layer facing the substrate, and in the direction perpendicular to the substrate, the auxiliary metal layer overlaps with the first active layer; and
the first transistor comprises a first gate located in the first metal layer and a second gate located in the auxiliary metal layer.

10. The display panel according to claim 9, wherein the display panel comprises a plurality of pixel driving circuits, at least one of which comprises a driving transistor, a data writing transistor, a threshold compensation transistor, and a first reset transistor, a gate of the driving transistor being connected to a first node, a first electrode of the driving transistor being connected to a second node, and a second electrode of the driving transistor being connected to a third node; a first electrode of the data writing transistor being connected to a data line, and a second electrode of the data writing transistor being connected to the second node; a first electrode of the threshold compensation transistor being connected to the third node, and a second electrode of the threshold compensation transistor being connected to the second node; a first electrode of the first reset transistor being connected to a first reset signal line, and a second electrode of the first reset transistor being connected to the first node; and
the first transistor comprises at least one of the driving transistor, the threshold compensation transistor, or the first reset transistor.

11. The display panel according to claim 10, wherein the first transistor comprises the driving transistor, the first gate of the driving transistor is connected to the first node, and the second gate of the driving transistor is connected to the data line.

12. The display panel according to claim 10, wherein the first transistor comprises the threshold compensation transistor and/or the first reset transistor, and the first gate/the first gates of the threshold compensation transistor and/or the first reset transistor are electrically connected to the second gate/the second gates of the threshold compensation transistor and/or the first reset transistor.

13. The display panel according to claim 10, wherein the at least one of the pixel driving circuits further comprises a first switch control transistor and a second switch control transistor, a first electrode of the first switch control transistor being connected to a power supply signal terminal, a second electrode of the first switch control transistor being connected to the second node, a first electrode of the second switch control transistor being connected to the third node, and a second electrode of the second switch control transistor being connected to a light-emitting element; and
the first transistor comprises the first switch control transistor and the second switch control transistor.

14. The display panel according to claim 1, wherein the first semiconductor layer comprises a first sub-layer and a second sub-layer, the main body is located in the first sub-layer, and the first protruding portion and the second protruding portion are located in the second sub-layer; and
the array layer further comprises at least one capacitor, a first electrode plate of the at least one capacitor being located at least in the second sub-layer, and the second electrode plate of the at least one capacitor being located at least in the first metal layer.

15. The display panel according to claim 14, wherein
the array layer comprises a first signal line provided in a different layer from the first electrode plate, the first electrode plate being electrically connected to the first signal line via a connection hole; and
the array layer comprises a second signal line provided in a same layer as the second electrode plate, the second electrode plate being electrically connected to the second signal line.

16. The display panel according to claim 14, wherein in the direction perpendicular to the plane where the substrate is located, the first metal layer and the first semiconductor layer are separated by a gate insulating layer.

17. The display panel according to claim 14, wherein in the direction perpendicular to the plane where the substrate is located, no other metal layer exists between the first metal layer and the second metal layer.

18. A method for manufacturing a display panel, comprising:
providing a substrate;
manufacturing a first sub-layer of a first semiconductor layer on a side of the substrate, and manufacturing a second sub-layer of the first semiconductor layer on a side of the first sub-layer facing away from the substrate;
removing at least parts of the first sub-layer and the second sub-layer to form a first active layer of a first transistor, the first active layer comprising a main body located in the first sub-layer and a first protruding portion and a second protruding portion located in the second sub-layer;
manufacturing a gate insulating layer on a side of the second sub-layer facing away from the substrate;
manufacturing a first metal layer on a side of the gate insulating layer facing away from the substrate, and forming a gate of a first transistor in the first metal layer;
manufacturing an interlayer insulating layer on the side of the first metal layer facing away from the substrate;
forming a first connection hole and a second connection hole in the interlayer insulating layer and the gate insulating layer by using the first protruding portion and the second protruding portion as alignment structures, so that the first connection hole exposes the first protruding portion, and the second connection hole exposes the second protruding portion;
manufacturing a second metal layer on the side of the interlayer insulating layer facing away from the substrate, forming a first electrode and a second electrode of the first transistor, so that the first electrode is electrically connected to the first protruding portion through the connection hole, and the second electrode is electrically connected to the second protruding portion through the connection hole.

19. The method according to claim 18, wherein the first sub-layer and the second sub-layer are formed continuously in a same vacuum film-forming chamber.

20. The method according to claim 19, wherein during manufacturing the second sub-layer, film-forming parameters of the vacuum film-forming chamber are adjusted, so that an indium content during manufacturing the second sub-layer is higher than an indium content during manufacturing the first sub-layer.

21. The method according to claim 18, wherein
while forming the first active layer of the first transistor, the first sub-layer and the second sub-layer are further used to form a first electrode plate of a capacitor;
while forming the gate of the first transistor in the first metal layer, the first metal layer is further used to form a second electrode plate of the capacitor; and
the first electrode plate overlaps with the second electrode plate in a direction perpendicular to the plane where the substrate is located.

22. The method according to claim 18, wherein the removing at least parts of the first sub-layer and the second sub-layer comprises: removing at least parts of the first sub-layer and the second sub-layer by a half-tone mask process, or removing at least parts of the first sub-layer and the second sub-layer separately by two mask processes.

23. A display apparatus, comprising the display panel according to any one of claims 1 to 17.
